(19) Europäisches Patentamt
European Patent Office
Office européen des brevets

(11) Veröffentlichungsnummer: **0 336 213 B1**

(12) **EUROPÄISCHE PATENTSCHRIFT**

(45) Veröffentlichungstag der Patentschrift: **11.01.95**

(51) Int. Cl.$^6$: **C07F 7/18**, G03C 1/72, G11B 7/24

(21) Anmeldenummer: **89105096.5**

(22) Anmeldetag: **22.03.89**

Die Akte enthält technische Angaben, die nach dem Eingang der Anmeldung eingereicht wurden und die nicht in dieser Patentschrift enthalten sind.

# (54) Siliciumnaphthalocyanine sowie dünne strahlungsempfindliche Beschichtungsfilme, die diese Verbindungen enthalten.

(30) Priorität: **31.03.88 DE 3810956**

(43) Veröffentlichungstag der Anmeldung:
**11.10.89 Patentblatt 89/41**

(45) Bekanntmachung des Hinweises auf die Patenterteilung:
**11.01.95 Patentblatt 95/02**

(84) Benannte Vertragsstaaten:
**BE CH DE ES FR GB IT LI NL**

(56) Entgegenhaltungen:
**EP-A- 0 191 970**
**EP-A- 0 254 553**

(73) Patentinhaber: **BASF Aktiengesellschaft**
**Carl-Bosch-Strasse 38**
**D-67063 Ludwigshafen (DE)**

(72) Erfinder: **Albert, Bernhard, Dr.**
**Rietburgstrasse 13**
**D-6701 Maxdorf (DE)**
Erfinder: **Neumann, Peter, Dr.**
**Poststrasse 28**
**D-6800 Mannheim 31 (DE)**
Erfinder: **Brosius, Sibylle, Dr.**
**L 9,3**
**D-6800 Mannheim 1 (DE)**

EP 0 336 213 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft neue Siliciumnaphthalocyanine, bei denen einer oder beide der am zentralen Siliciumatom befindlichen Liganden ein weiteres Siliciumatom enthält, sowie dünne strahlungsempfindliche Beschichtungsfilme, enthaltend einen Träger und eine gegenüber Strahlung empfindliche Schicht, die die neuen Verbindungen enthält.

Aufzeichnungsmaterialien, die mit Strahlen hoher Energiedichte, z.B. Laserlicht, eine lokal begrenzte Zustandsänderung erfahren, sind bekannt. Mit dieser thermisch ausgelösten Zustandsänderung, z.B. Verdampfen, Änderung des Fließverhaltens oder Ausbleichen, ist eine Änderung der optischen Eigenschaften, beispielsweise der Reflexion oder Absorption durch Änderung des Absorptionsmaximums oder der Extinktion verbunden, welche zur Informations- oder Datenaufzeichnung ausgenutzt werden kann.

Als Lichtquelle für ein optisches Aufnahmesystem eignen sich beispielsweise Halbleiterlaser, die Licht im nahen Infrarot emittieren. Festkörper-Injektionslaser, vor allem der AlGaAs-Laser, der im Wellenlängenbereich zwischen etwa 650 und 900 nm arbeitet, sind hierbei besonders zu nennen. Daher besteht besonders Interesse an solchen Aufzeichnungsmaterialien, die Strahlung im Wellenlängenbereich zwischen ca. 650 und 900 nm absorbieren und sich zu dünnen, homogenen Schichten verarbeiten lassen.

Aus J. Am. Chem. Soc. Band 106, S. 7404 bis 7410,1984, sowie aus der EP-A-191 215 sind bereits einige Siliciumnaphthalocyanine bekannt, deren Liganden, die sich am zentralen Siliciumatom befinden, jeweils noch ein Siliciumatom enthalten. Es hat sich jedoch gezeigt, daß die dort beschriebenen Verbindungen bei ihrer Anwendung in optischen Speichern noch Mängel aufweisen.

Auch aus der EP-A-191 970 und der EP-A-254 553 sind Siliciumnaphthalocyanine bekannt, deren zentrales Siliciumatom Liganden aufweist, die weitere Siliciumatome enthalten.

Aufgabe der vorliegenden Erfindung war es, neue strahlungsempfindliche Produkte bereitzustellen, die im Wellenlängenbereich der verwendeten Halbleiterlaser eine gute Reflektion und eine hohe Absorption aufweisen. Der Erfindung lag weiterhin die Aufgabe zugrunde, neue strahlungsempfindliche Beschichtungsfilme bereitzustellen, wobei die die neuen Produkte enthaltenden Schichten homogen sein, eine gute Haftung auf den gebräuchlichen Trägermaterialien aufweisen und über einen langen Zeitraum hinweg stabil sein sollten.

Es wurden nun neue Siliciumnaphthalocyanine der Formel I

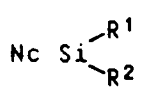

(I)

gefunden, in der

Nc den Rest eines Naphthalocyaninsystems, das gegebenenfalls durch $C_1$-$C_{10}$-Alkyl oder $C_1$-$C_{10}$-Alkoxy substituiert ist, und

$R^1$ und $R^2$ gleich oder verschieden sind und unabhängig voneinander jeweils einen Rest der Formel

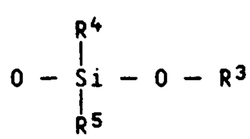

,

in der $R^3$ für verzweigtes $C_6$-$C_{20}$-Alkyl der Formel

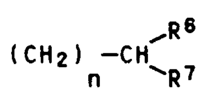

,

wobei n die Bedeutung von 1 bis 5 und $R^6$ und $R^7$ gleich oder verschieden sind und unabhängig voneinander jeweils die Bedeutung von $C_1$-$C_{16}$-Alkyl besitzen, und $R^4$ und $R^5$ gleich oder verschieden sind und unabhängig voneinander jeweils für $C_1$-$C_{10}$-Alkyl oder den Rest $OR^3$, in dem $R^3$ die obengenannte Bedeutung besitzt, stehen, oder der Rest $R^1$ auch $C_1$-$C_{10}$-Alkyl bedeuten.

Die neuen Siliciumnaphthalocyanine eignen sich in vorteilhafter Weise als strahlungsempfindliche Komponenten in dünnen strahlungsempfindlichen Beschichtungsfilmen.

Alle in den obengenannten Resten auftretenden Alkylgruppen können, sofern nicht anders vermerkt, sowohl geradkettig als auch verzweigt sein.

Geeignete Substituenten für das Naphthalocyaninsystem sind ebenso wie die Reste $R^1$, $R^4$, $R^5$, $R^6$ und $R^7$ z.B. Methyl, Ethyl, Propyl, Isopropyl, Butyl, Isobutyl, sec-Butyl, tert-Butyl, Pentyl, Isopentyl, Neopentyl, tert-Pentyl, Hexyl, 2-Methylpentyl, Heptyl, Octyl, 2-Ethylhexyl, Isoocytyl, Nonyl, Isononyl, Decyl oder Isodecyl.

Geeignete Substituenten für das Naphthalocyaninsystem sind weiterhin z.B. Methoxy, Ethoxy, Propoxy, Isopropoxy, Butoxy, Isobutoxy, Pentyloxy, Hexyloxy, Heptyloxy, Octyloxy, 2-Ethylhexyloxy, Isooctyloxy, Nonyloxy, Isononyloxy, Decyloxy oder Isodecyloxy.

Reste $R^6$ und $R^7$ sind weiterhin z.B. Undecyl, Dodecyl, Tridecyl, 3,5,5,7-Tetramethylnonyl, Isotridecyl, Tetradecyl, Pentadecyl oder Hexadecyl. (Die obigen Bezeichnungen Isooctyl, Isononyl, Isodecyl und Isotridecyl sind Trivialbezeichnungen und stammen von den nach der Oxosynthese erhaltenen Alkoholen - vgl. dazu Ullmanns Enzyklopädie der technischen Chemie, 4. Auflage, Band 7, Seiten 215 bis 217, sowie Band 11, Seiten 435 und 436.)

Wichtige Substituenten für das Naphthalocyaninsystem sind z.B. $C_1$-$C_4$-Alkyl, $C_5$-$C_{10}$-Alkyl, $C_1$-$C_4$-Alkoxy oder $C_5$-$C_{10}$-Alkoxy.

Wichtige Reste $R^3$ sind z.B. $C_6$-$C_{10}$-Alkyl, $C_{10}$-$C_{15}$-Alkyl oder $C_{16}$-$C_{20}$-Alkyl.

Wichtige Reste $R^1$, $R^4$ und $R^5$ sind z.B. $C_1$-$C_4$-Alkyl oder $C_5$-$C_{10}$-Alkyl.

Wichtige Reste $R^6$ und $R^7$ sind z.B. $C_1$-$C_6$-Alkyl, $C_7$-$C_{12}$-Alkyl oder $C_{13}$-$C_{16}$-Alkyl.

Bevorzugt sind solche Siliciumnaphthalocyanine der Formel I, in der Nc den Rest eines unsubstituierten Naphthalocyaninsystems bedeutet.

Die erfindungsgemäßen Siliciumnaphthalocyanine können nach an sich bekannten Methoden, wie sie beispielsweise in J. Org. Chem. USSR (Engl. Transl.) Band 7, S. 364 bis 366, 1971, und J. Am. Chem. Soc. Band 106, S. 7404 bis 7410, 1984 beschrieben sind, erhalten werden.

Als Ausgangsprodukte dienen beispielsweise die entsprechenden Diiminoisoindoline der Formel II

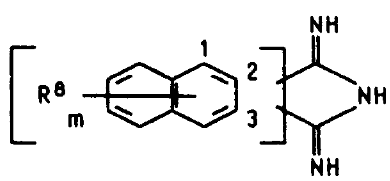

(II),

in der $R^8$ Wasserstoff, $C_1$-$C_{10}$-Alkyl oder $C_1$-$C_{10}$-Alkoxy und m 1 oder 2 bedeuten und in der die zur Naphthalocyaninbildung befähigten Substituenten jeweils orthoständig (Position 1 und 2 oder 2 und 3) verknüpft sind.

Die Isoindoline der Formel II können dabei mit Chlorsilanen der Formel III

$XSiCl_3$ (III),

in der X für $C_1$-$C_{10}$-Alkyl oder Chlor steht, in einem inerten organischen Verdünnungsmittel in Gegenwart einer Base bei einer Temperatur von 170 bis 250 °C zu Chlorsiliciumnaphthalocyaninen der Formel IV

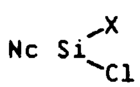

(IV),

in der Nc und X jeweils die obengenannte Bedeutung besitzen, umgesetzt werden.

Geeignete Verdünnungsmittel sind z.B. Tetralin oder Nitrobenzol. Als Basen kommen z.B. tertiäre Amine, wie Tributylamin, Chinolin, Picoline oder Collidine in Betracht.

Die Chlorsiliciumnaphthalocyanine IV können dann mit konzentrierter Schwefelsäure bei einer Temperatur von 5 bis 50 °C in die entsprechenden Hydroxyverbindungen der Formel V

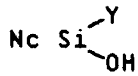 (V),

in der Y Hydroxy oder $C_1$-$C_{10}$-Alkyl bedeutet und Nc die obengenannte Bedeutung besitzt, übergeführt werden.

Durch Reaktion der Hydroxyverbindungen V zunächst mit Chlorsilanen der Formel VI

$X_2SiCl_2$ (VI),

in der X die obengenannte Bedeutung besitzt, in Pyridin in Gegenwart von Natriumhydrid bei einer Temperatur von 15 bis 150 °C und anschließend mit Alkoholen der Formel VII

$R^3$-OH (VII),

in der $R^3$ die obengenannte Bedeutung besitzt, bei einer Temperatur von 30 bis 120 °C kann man schließlich zu den erfindungsgemäßen Siliciumnaphthalocyaninen der Formel I gelangen.

Die neuen Siliciumnaphthalocyanine der Formel I weisen im nahen Infrarot eine hohe molare Absorption auf. Sie bilden homogene, amorphe Schichten und/oder lassen sich in Farbstoff-in-Polymer-Schichten vorteilhaft einarbeiten.

Die Erfindung betrifft weiterhin dünne strahlungsempfindliche Beschichtungsfilme, enthaltend einen Träger und eine gegenüber Strahlung empfindliche Schicht, wobei die gegenüber Strahlung empfindliche Schicht ein Siliciumnaphthalocyanin der Formel I enthält.

Bevorzugt sind dabei solche strahlungsempfindliche Beschichtungsfilme, die ein Siliciumnaphthalocyanin der Formel I, in der Nc den Rest eines unsubstituierten Naphthalocyaninsystems bedeutet, enthalten.

Als weitere Komponenten der dünnen Beschichtungsfilme kommen Polymerisate in Betracht, welche mit den Verbindungen der Formel I verträglich sind. Solche Polymerisate werden im allgemeinen als Bindemittel bezeichnet.

Beispiele geeigneter Bindemittel sind Polystyrole, Polyester, Polyacrylate, Polymethacrylate, Polycarbonate, Polyamine, Polyvinylalkohole, Polyvinylchloride, Copolymere von Vinylchlorid und Vinylacetat oder flüssigkristalline Seitengruppen enthaltende Polymerisate oder Copolymerisate gemäß der EP-A-90 282 oder EP-A-171 045.

Darüber hinaus können die Filme weitere geeignete Zusatzstoffe, wie niedermolekulare flüssigkristalline Verbindungen enthalten.

Bevorzugt sind solche Filme, die nur aus den Siliciumnaphthalocyaninen der Formel I bestehen und wobei die Farbstoffe in amorphem Zustand vorliegen.

Der Begriff "amorph" gibt dabei an, daß der Beschichtungsfilm keine anisotropen Bereiche aufweist, die größer sind als ein Bruchteil der thermisch veränderten Bereiche, sondern daß er in der Größenordnung von ca. 30 nm und darüber optisch isotrop ist.

Im allgemeinen beträgt die Dicke der Filme 20 bis 400 nm, vorzugsweise 50 bis 300 nm.

Vorzugsweise absorbieren die in den erfindungsgemäßen Beschichtungsfilmen enthaltenen Farbstoffe Laserlicht, insbesondere Laserlicht relativ langer Wellenlänge (650 bis 900 nm).

Bevorzugt sind solche Beschichtungsfilme, die auf einem scheibenförmigen Träger, gegebenenfalls mit einer Reflektorschicht, aufgebracht sind, und die das Schreiben und die Wiedergabe von Informationen mittels eines Halbleiterlasers ermöglichen.

Ein so aufgebauter optischer Speicher kann eine Information hoher Dichte in Form spiraler oder kreisförmig konzentrischer Wege, feiner Löcher oder Vertiefungen (von etwa 1 µm Breite) , welche optisch durch Änderung der Reflektivität gegenüber der Umgebung feststellbar sind, aufnehmen. Er zeigt einen guten Kontrast.

Aufgrund der hohen Lichtabsorption der Farbstoffe sind die erfindungsgemäßen Beschichtungsfilme sehr empfindlich gegenüber dem Licht des Halbleiter-Lasers.

Der Aufbau der Aufzeichnungsmedien ist an sich bekannt.

Als Träger kommen z.B. Glasplatten oder -scheiben oder Kunststoffplatten oder -scheiben, insbesondere Platten oder Scheiben aus Polymethylmethacrylat, Polystyrol, Polystyrol-Copolymeren, Polyvinylchlorid, Polymethylpenten oder Polycarbonat in Betracht, die gegebenenfalls Spurrillen aufweisen.

Der Träger kann dabei die Form eines Bandes, einer quadratischen oder rechteckigen Platte oder einer runden Scheiben haben, wobei die für laseroptische Aufzeichnungsmaterialien üblichen und bekannten

Scheiben eines Durchmessers von 10 oder 13 cm bevorzugt werden.

Darüber hinaus können die Aufzeichnungsmaterialien weitere Schichten, wie Schutzschichten, Haftschichten oder Elektrodenschichten aufweisen.

Neben dem Träger kann weiterhin eine reflektierende Schicht vorhanden sein, so daß das eingestrahlte und durch die farbige Schicht wandernde Licht, so weit es nicht absorbiert wird, an der Reflektorschicht reflektiert wird und nochmals durch die gefärbte Schicht wandert.

Die Belichtung erfolgt bevorzugt durch ein transparentes Substrat. Als Schichtfolge kommt dann in Frage: Substrat-Absorberschicht- gegebenenfalls Reflektor.

Der Träger oder die Licht reflektierende Schicht muß eine optisch glatte, ebene Oberfläche aufweisen, die so beschaffen sein muß, daß die absorbierende Schicht fest darauf haftet. Um die Oberflächenqualität und Adhäsionsphänomene günstig zu beeinflussen, kann der Träger und/oder der Reflektor mit einer Glättungsschicht aus einem duroplastischen oder thermoplastischen Material versehen werden.

Sofern die gegenüber Strahlung empfindliche Schicht keine ausreichende mechanische Stabilität aufweist, kann sie mit einer transparenten Schutzschicht überzogen werden. Hierzu bieten sich eine Reihe von Polymeren an, welche durch Aufschleudern, Aufrakeln oder Tauchen von gelösten Polymeren oder durch Aufdampfen im Vakuum, vornehmlich von fluorierten Polymeren, eine Schutzschicht bilden können.

Wenn der Datenspeicher aus zwei gleichen oder verschiedenen Aufzeichnungsmedien in Form eines "Sandwich" aufgebaut wird, kann auf eine Schutzschicht verzichtet werden. Neben größerer mechanischer und rotationsdynamischer Stabilität bietet der "Sandwich"-Aufbau den Vorteil der doppelten Speicherkapazität.

Auf die Schutz- und/oder Zwischenschichten kann bei ausreichender Qualität des optischen Aufzeichnungsmediums aber auch verzichtet werden.

Die erfindungsgemäßen dünnen Beschichtungsfilme, die die neuen Siliciumnaphthalocyanine enthalten, absorbieren stark bei der Wellenlänge der Halbleiterlaser von ca. 650 bis 900 nm. Die Siliciumnaphthalocyanine können so aufgebracht werden, daß sich glatte Absorptionsschichten von optischer Qualität ergeben, in die die zu speichernde Information mit hohem Signal:Rausch-Verhältnis eingeschrieben werden kann.

Das Aufbringen der Absorptionsmaterialien erfolgt vorzugsweise durch Aufschleudern von gelöstem oder dispergiertem Farbstoff, gegebenenfalls in Gegenwart von Bindemitteln. Auch Rakeln oder Tauchen kommen als Schichtbildungsverfahren in Frage. Das Aufbringen z.B. von metallischen Reflektionsschichten erfolgt vorzugsweise durch Aufdampfen im Vakuum oder durch Aufbringen geeigneter Metallfolien auf den Träger.

Für das Aufbringen der Absorptionsschichten aus Lösung bereitet man in einem geeigneten Lösungsmittel, wie Cyclohexan, Methylcyclohexan, Methylenchlorid, Chloroform, Tetrachlorkohlenstoff, Bromoform, 1,1,1-Trichlorethan, 1,1,2-Trichlorethan, Aceton, Methylethylketon, Cyclohexanon, Toluol, Acetonitril, Essigester, Methanol, Ethanol oder Mischungen dieser Lösungsmittel, eine Lösung oder gegebenenfalls eine Dispersion des Siliciumnaphthalocyanins oder Gemischen dieser Verbindungen und des Bindemittels und setzt gegebenenfalls ein Hilfsmittel zu.

Diese Farbstoffzubereitung wird dann durch Rakeln oder Tauchen, vorzugsweise aber durch Aufschleudern ("Spin-coating") auf ein vorher gereinigtes oder gegebenenfalls vorbehandeltes Substrat ("Subbing-layer") aufgebracht und die Schicht an der Luft getrocknet oder gehärtet. Der Film kann auch im Vakuum bei erhöhter Temperatur, oder gegebenenfalls mit Strahlung getrocknet oder gehärtet werden.

Wie bereits oben ausgeführt, sind solche strahlungsempfindliche Beschichtungsfilme bevorzugt, die nur aus einer Schicht bestehen, inbesondere solche, bei denen diese Schicht mittels Spin-coating aufgebracht wird.

Je nach Systemaufbau wird zuerst die strahlungempfindliche Schicht und dann der Reflektor aufgebracht oder umgekehrt verfahren. Auf das Aufbringen von Zwischen- oder Schutzschichten oder einer reflektierenden Schicht kann, wie bereits oben ausgeführt, gegebenenfalls auch verzichtet werden.

Bevorzugt ist ein Monoschichtsystem ohne Reflektor.

Die erfindungsgemäßen strahlungsempfindlichen Beschichtungsfilme können mittels eines Schreiblaserstrahls mit analogen oder digitalen Daten beschrieben werden, wobei man zum Einschreiben analoger Daten bekanntermaßen einen analog modulierten Dauerstrichlaser und zum Einschreiben digitaler Daten einen impulskodierten Laser verwendet.

Im allgemeinen weisen geeignete Laser bei der Schreibwellenlänge eine Strahlleistung von 1 bis 20 mW auf. Der Fokus-Durchmesser des Schreiblaserstrahls liegt im allgemeinen bei 300 bis 2000 nm. Überlicherweise beträgt die Impulsdauer bei der Bestrahlung mit einem impulscodierten Laser 10 bis 1000 ns. Vorteilhaft verwendet man zum Einschreiben einen Laserstrahl mit Licht einer Wellenlänge, die von der betreffenden Aufzeichnungsschicht gut absorbiert wird. Vorteilhaft sind Wellenlängen von 400 bis 1000 nm.

Beim Schreibvorgang wird der Laserstrahl in relativer Bewegung über das Aufzeichnungsmaterial hinweggeführt und trifft dabei senkrecht auf dieses auf, wobei er auf die Aufzeichnungsschicht fokussiert ist. An der Auftreffstelle wird die Aufzeichnungsschicht lokal erhitzt und es entstehen thermisch veränderte Bereiche, beispielsweise in der Form von Löchern, Kratern oder Flecken. Beim Einschreiben von Daten mit impulskodierten Lasern haben diese Bereiche im wesentlichen eine runde oder ovale Form mit einem Durchmesser von 100 bis 2000 nm. Beim Einschreiben mit einem analog modulierten Dauerstrichlaser können sie beliebige Formen haben.

Die erfindungsgemäßen Beschichtungsfilme eignen sich ausgezeichnet für die laseroptische Datenaufzeichnung.

Das Schreiben der Daten in die Aufzeichnungsschicht kann von der dem Träger abgewandten Seite der Schicht her oder durch den optisch klaren Träger hindurch erfolgen. Letzteres ist von besonderem Vorteil.

Die eingeschriebenen Daten werden mit Hilfe eines Leselaserstrahls gelesen. Die Strahlleistung des Leselasers bei der Lesewellenlänge liegt unterhalb der Schwellenleistung ab der ein Beschreiben möglich wird. Im allgemeinen liegt die Strahlleistung bei 0,1 bis 1,5 mW. Vorteilhaft verwendet man Laserlicht einer Wellenlänge, die von der Aufzeichnungsschicht stark reflektiert wird. Vorteilhaft ist eine Wellenlänge von 400 bis 1000 nm, insbesondere 630 bis 900 nm.

Auch beim Lesevorgang wird der Leselaserstrahl in relativer Bewegung über das Aufzeichnungsmaterial hinweggeführt und trifft senkrecht auf dieses auf, wobei er auf die Aufzeichnungsschicht fokussiert ist.

Trifft der Leselaserstrahl beim Überstreichen der Aufzeichnungsschicht auf einen thermisch veränderten Bereich, beispielsweise einen Fleck, so ändern sich die Eigenschaften des vom Aufzeichnungsmaterials transmittierten oder reflektierten Lichts, was mit Hilfe geeigneter Detektoren nachgewiesen werden kann.

Dabei kann das Lesen der Daten in der Aufzeichnungsschicht von der dem Träger abgewandten Seite der Schicht her oder durch die optisch klaren, transparenten Träger hindurch erfolgen, wobei letzteres von Vorteil ist. Hierbei ist es besonders vorteilhaft, das reflektierte Licht zu erfassen.

Außerdem ist es von besonderem Vorteil, hierzu Schreib- und Leselaser zu verwenden, die im infraroten Wellenlängenbereich von 650 bis 900 nm ausstrahlen. Dabei ist es außerdem von Vorteil, wenn die Schreibwellenlänge mit der Lesewellenlänge identisch ist oder sich nur wenig von ihr unterscheidet. Licht dieser Wellenlängen wird von üblichen und bekannten Halbleiter-Lasern geliefert.

Die erfindungsgemäßen Beschichtungsfilme weisen zahlreiche besondere Vorteile auf. So ist ihre unbeschriebene Aufzeichnungsschicht besonders stabil, so daß sie sich selbst nach langer Lagerzeit bei vergleichsweise hoher Temperatur- und Luftfeuchtigkeit noch immer hervorragend für die laseroptische Datenaufzeichnung eignet. Gleiches gilt für die beschriebene Aufzeichnungsschicht; hier tritt selbst bei sehr langer Lagerung kein Informationsverlust ein. Es können daher auch Schreiblaser mit vergleichsweise geringer Lichtleistung verwendet werden. Außerdem weisen die beschriebenen Aufzeichnungsmaterialien einen ganz besonders hohen optischen Kontrast zwischen beschriebenen und unbeschriebenen Bereichen auf, welcher den bisher bekannten optischen Kontrast beschriebener Phthalocyaninschichten übertrifft. Des weiteren wird bei den neuen Aufzeichnungsmaterialien eine Bitdichte von deutlich über $10^7$ bits/$cm^2$ erreicht, wobei die Daten dann auch noch unmittelbar nach dem Einschreiben gelesen werden können.

Die erfindungsgemäßen Siliciumnaphthalocyanine der Formel I weisen weitere sehr gute anwendungstechnische Eigenschaften auf und können daher auch für andere Verwendungszwecke dienen. Insbesondere können sie für die Herstellung von IR-Schutzschichten, IR-absorbierenden Folien, Sonnenbrillenbeschichtungen, Beschichtungen für Autowindschutzscheiben, IR-Tinten, Druckfarben für IR-lesebare Streifencodes, Flüssigkristallanzeigen oder IR-Sicherheitssystemen verwendet werden.

Unter IR-lesbaren Streifencodes sind beispielsweise die auf Warenverpackungen angebrachten Streifencodes zu verstehen, welche der genauen Kennzeichnung der Waren dienen.

Unter Flüssigkristallanzeigen oder "Displays" werden die bekannten Anordnungen verstanden, welche Schichtdicken aus flüssig-kristallinen Stoffen enthalten. Diese Schichten ändern bei Anlegen einer elektrischen Spannung lokal ihre optischen Eigenschaften, wodurch z.B. Zahlen, Buchstaben oder Bilder sichtbar dargestellt (angezeigt) werden können.

Unter IR-Sicherheitssystemen werden Anordnungen verstanden, welche im wesentlichen aus einer Laserlichtquelle und einem geeigneten, räumlich weiter davon entfernten Detektor bestehen. Der von der Laserlichtquelle ausgesandte Laserstrahl trifft dabei auf den Detektor und bildet eine sogenannten Lichtschranke. Wird diese unterbrochen, so wird über den Detektor ein Alarm ausgelöst.

Elektrophotographische Aufzeichnungsmaterialien enthalten im wesentlichen Schichten, welche in der Dunkelheit einen hohen elektrischen Widerstand aufweisen, wohingegen sie bei der Belichtung leitfähig werden. Werden solche Schichten in der Dunkelheit an ihrer Oberfläche elektrostatisch aufgeladen und anschließend bildmäßig belichtet, so wird die elektrostatische Ladung in den belichteten Bereichen abgeleitet und es entsteht ein elektrostatisches Bild, welches mit Hilfe sogenannter Toner sichtbar gemacht werden

kann.

Die folgenden Beispiele sollen die Erfindung näher erläutern.

A) Synthese

Beispiel 1

a) Synthese von

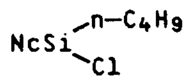

(Sofern nicht anders vermerkt, bezieht sich der Rest Nc in den Beispielen jeweils auf den unsubstituierten Rest des Naphthalocyaninsystems. )

20 g n-Butyl-trichlorsilan und 11 g 1,3-Diiminobenzo-[f]-isoindolin wurden in 150 ml Chinolin 3 Stunden auf 195 °C, erhitzt. Nach dem Abkühlen gab man 250 ml Methanol zu, saugte ab und wusch mit Methanol.

b) Synthese von

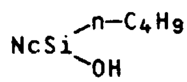

Die unter a) erhaltene Verbindung wurde bei Raumtemperatur 20 Stunden mit konzentrierter Schwefelsäure gerührt. Danach gab man das Reaktionsgemisch auf Eiswasser, saugte ab und wusch mit Wasser und Methanol.

c) Synthese von

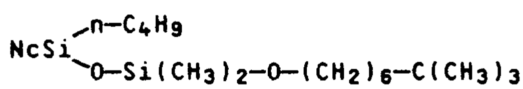

5 g der unter b) beschriebenen Verbindung wurden zu einer Mischung aus 150 ml Pyridin, 50 ml Toluol und 10 ml Tributylamin gegeben. Man gab dann 0,5 g Natriumhydrid zu und rührte 3 Stunden bei 80 °C. Nach dem Erkalten wurden 20 ml Dimethyl-dichlorsilan [$(CH_3)_2SiCl_2$] zugegeben, über Nacht bei Raumtemperatur gerührt und danach ca. 100 ml des Reaktionsgemischs abdestilliert.

Nach Zugabe von 7 ml 7,7-Dimethyloctan-1-ol wurde 6 Stunden unter Rückfluß gekocht, danach unter den gleichen Bedingungen alle flüchtigen Anteile weitgehend abdestilliert, abgekühlt und mit ca. 200 ml Methanol versetzt.

Das Zielprodukt wurde abgesaugt und mit Methanol gewaschen.

Die in der folgenden Tabelle 1 aufgeführten Verbindungen der Formel

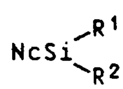

wurden in analoger Weise erhalten. Zusätzlich aufgeführt sind dabei das in Stufe c) verwendete Silan sowie der in Stufe c) verwendete Alkohol.

Zur Charakterisierung dieser Verbindungen sind in Tabelle 2 ihre Rf-Werte angegeben.

Tabelle 1

| Beispiel Nr. | $R^1 = R^2$ | Silan | Alkohol |
|---|---|---|---|
| 2 | $O-Si(CH_3)_2-O-n-C_8H_{17}$ | $(CH_3)_2SiCl_2$ | $n-C_8H_{17}OH$ |
| 3 | $O-Si(CH_3)_2-O-(CH_2)_2-OCH_3$ | $(CH_3)_2SiCl_2$ | $CH_3O(CH_2)_2OH$ |
| 4 | $O-Si(CH_3)_2-O-(CH_2)_2-O-(CH_2)_2-O-n-C_4H_9$ | $(CH_3)_2SiCl_2$ | $n-C_4H_9O(CH_2)_2O(CH_2)_2OH$ |
| 5 | $O-Si(CH_3)_2-O-(CH_2)_6-OH$ | $(CH_3)_2SiCl_2$ | $HO(CH_2)_6OH$ |
| 6 | $O-Si(CH_3)_2-O-CH(n-C_8H_{17})_2$ | $(CH_3)_2SiCl_2$ | $(n-C_8H_{17})_2CHOH$ |
| 7 | $O-Si(CH_3)_2-O-n-C_{18}H_{37}$ | $(CH_3)_2SiCl_2$ | $n-C_{18}H_{37}OH$ |
| 8 | $O-Si(CH_3)_2-O-n-C_{12}H_{25}$ | $(CH_3)_2SiCl_2$ | $n-C_{12}H_{25}OH$ |
| 9 | $O-Si(CH_3)_2-O-(CH_2)_6-C(CH_3)_3$ | $(CH_3)_2SiCl_2$ | $(CH_3)_3C(CH_2)_6OH$ |
| 10 | $O-Si(O-n-C_8H_{17})_3$ | $SiCl_4$ | $n-C_8H_{17}OH$ |
| 11 | $O-Si(O-n-C_{12}H_{25})_3$ | $SiCl_4$ | $n-C_{12}H_{25}OH$ |
| 12 | $O-Si(O-n-C_{18}H_{37})_3$ | $SiCl_4$ | $n-C_{18}H_{37}OH$ |
| 13 | $O-Si[O-(CH_2)_6-C(CH_3)_3]$ | $SiCl_4$ | $(CH_3)_3C(CH_2)_6OH$ |
| 14 | $O-Si(n-C_4H_9)(O-CH_2-\underset{\mid\atop C_2H_5}{CH}-C_4H_9)_2$ | $Cl_3Si-n-C_4H_9$ | $\genfrac{}{}{0pt}{}{C_4H_9}{C_2H_5}\!>CHCH_2OH$ |
| 15 | $O-Si(-CH_2-CH_2-CH(CH_3)_2)(O-CH_2-\underset{\mid\atop C_2H_5}{CH}-C_4H_9)$ | $Cl_3Si-(CH_2)_2-CH(CH_3)_2$ | $\genfrac{}{}{0pt}{}{C_4H_9}{C_2H_5}\!>CHCH_2OH$ |

Tabelle 1 - Forts.

| Beispiel Nr. | $R^1 = R^2$ | Silan | Alkohol |
|---|---|---|---|
| 16 | $O-Si(CH_3)_2-O-(CH_2)_4-CH(CH_3)_2$ | $(CH_3)_2SiCl_2$ | $(CH_3)_2CH(CH_2)_4OH$ |
| 17 | 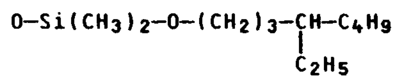 | $(CH_3)_2SiCl_2$ | 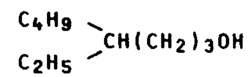 |
| 18 | 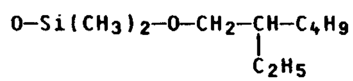 | $(CH_3)_2SiCl_2$ | 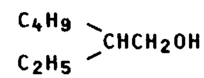 |
| 19 | 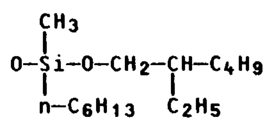 | 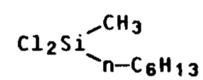 | 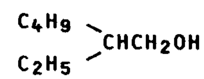 |
| 20 | 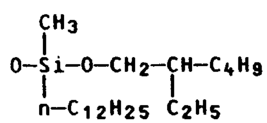 | 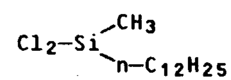 | 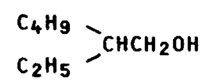 |

Tabelle 2

| $R_f$-Werte | | | |
|---|---|---|---|
| Beispiel Nr. | Fließmittel: | | |
| | A | B | C |
| 1 | | 0,42 | 0,89 |
| 2 | 0,55 | 0,43 | 0,84 |
| 3 | | 0,10 | |
| 4 | | 0,66 | |
| 5 | | 0,66 | 0,84 |
| 6 | | 0,90 | |
| 7 | 0,57 | 0,83 | 0,87 |
| 8 | | 0,53 | |
| 9 | 0,88 | 0,89 | 0,94 |
| 10 | | 0,08 | |
| 11 | | 0,15 | 0,98 |
| 12 | | 0,87 | 0,98 |
| 13 | | 0,98 | 0,96 |
| 14 | | 0,25 | 0,97 |
| 15 | | 0,48 | 0,97 |
| 16 | 0,62 | 0,65 | 0,94 |
| 17 | | 0,91 | 0,96 |
| 18 | 0,67 | 0,72 | 0,95 |
| 19 | | 0,44 | |
| 20 | | 0,75 | |

Die oben aufgeführten $R_f$-Werte wurde auf Kieselgel-Platten der Firma Macherey und Nagel (Polygram 0,2 mm, N-HR UV 254) gefunden.

Als Fließmittel diente dabei

A) Toluol

B) Toluol/Methylenchlorid (9:1 v/v)

C) Toluol/Aceton (9:1 v/v)

Herstellvorschrift für einen Beschichtungsfilm

1 g der Verbindung aus Beispiel 1c) wurde in 20 ml Toluol bei Raumtemperatur über Nacht gerührt und danach mittels Überdruck durch eine Fritte (P4) gepreßt. Die resultierende Lösung wurde dann mittels einer Spritze auf eine rotierende Scheibe aus Polymethylmethacrylat (Durchmesser 12 cm) aufgetragen. Die Lösung wurde dabei bei einer Drehzahl von 2000 U/min 25 sec lang abgeschleudert und anschließend 35 sec bei einer Drehzahl von 5000 U/min trockengeschleudert. Die erhaltene Schicht war homogen, pin-hole-frei und hochreflektierend.

B) Anwendung

Zum Beschreiben und Lesen des Aufzeichnungsmaterials, dessen Herstellung voranstehend beschrieben ist, wurde ein übliches und bekanntes Meßlaufwerk verwendet. Dieses wies

a) einen impulskodierten Schreiblaser, welcher Licht der Wellenlänge 836 nm mit einer maximalen Schreibleistung von 10 mW aussandte, und

b) einen Leselaser, welcher kontinuierlich Licht der Wellenlänge 780 nm mit einer Leistung von 0,4 bis 1 mW emittierte,

auf. Außerdem wies das Meßlaufwerk optische Bauteile auf, mit deren Hilfe die parallelen Laserstrahlen der Laser (a) und (b) kolinear ausgerichtet wurden, um dann mit einem gemeinsamen Objektiv (NA = 0,5) durch die Disks hindurch auf die Aufzeichnungsschichten fokussiert zu werden. Dadurch waren die Auftreffstellen der beiden Laserstrahlen nur um ca. 10 $\mu$m voneinander entfernt, so daß ein eingeschriebener Fleck infolge der Plattendrehung bereits wenige $\mu$s nach dem Einschreiben den Fokus des Leselasers (b) passierte und detektiert werden konnte.

Zwecks Detektion der Flecke wurde das von der Aufzeichnungsschicht durch die Disks hindurch reflektierte Licht in üblicher und bekannter Weise erfaßt.

Das Aufzeichnungsmaterial wurde bei einer Spurgeschwindigkeit von 4 $ms^{-1}$ mittels des Schreiblasers (a) mit kontinuierlichen Pulszügen (1 MHz square wave; Dauer der Einzelpulse: 500 ns) beschrieben. Dabei wurde die Schreibleistung zwischen 1 und 10 mW variiert. Unmittelbar, d.h. wenige $\mu$s nach ihrer Aufzeichnung, wurden die erhaltenen Flecke gelesen. Hierbei wurde die Amplitude der durch die Flecke hervorgerufenen Pulse des reflektierten Leselaserlichts gemessen und als Funktion der Schreibleistung, mit welcher der betreffenden Flecke ursprünglich erzeugt worden waren, aufgezeichnet. In dieser Weise wurde ermittelt, ab welcher Schreibleistung unter den oben angegebenen Bedingungen einwandfreie Signale - die Grundvoraussetzung der Datenaufzeichnung - erhalten werden konnten. Dies war ab einer Schreibleistung von 2,5 mW möglich, was die hohe Empfindlichkeit des erfindungsgemäßen Aufzeichnungsmaterials belegte.

Das Aufzeichnungsmaterial wurde zehn Wochen lang bei 60 °C und einer relativen Luftfeuchtigkeit von 90 % gelagert. Dabei traten keine nachteiligen Veränderungen ein, sondern die aufgezeichneten Daten konnten nach wie vor fehlerfrei gelesen werden.

## Patentansprüche

**1.** Siliciumnaphthalocyanine der Formel I

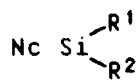

(I),

in der

| | |
|---|---|
| Nc | den Rest eines Naphthalocyaninsystems, das gegebenenfalls durch $C_1$-$C_{10}$-Alkyl oder $C_1$-$C_{10}$-Alkoxy substituiert ist, und |
| $R^1$ und $R^2$ | gleich oder verschieden sind und unabhängig voneinander jeweils einen Rest der Formel |

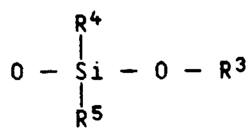

,

in der $R^3$ für verzweigtes $C_6$-$C_{20}$-Alkyl der Formel

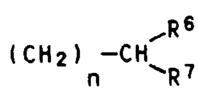

,

wobei n die Bedeutung von 1 bis 5 und $R^6$ und $R^7$ gleich oder verschieden sind und unabhängig voneinander jeweils die Bedeutung von $C_1$-$C_{16}$-Alkyl besitzen, und $R^4$ und $R^5$ gleich oder verschieden sind und unabhängig voneinander jeweils für $C_1$-$C_{10}$-Alkyl oder den Rest $OR^3$, in dem $R^3$ die obengenannte Bedeutung besitzt, stehen, oder der Rest $R^1$ auch $C_1$-$C_{10}$-Alkyl bedeuten.

**2.** Siliciumnaphthalocyanine der Formel I gemäß Anspruch 1, dadurch gekennzeichnet, daß Nc den Rest eines unsubstituierten Naphthalocyaninsystems bedeutet.

**3.** Dünne strahlungsempfindliche Beschichtungsfilme, enthaltend einen Träger und eine gegenüber Strahlung empfindliche Schicht, dadurch gekennzeichnet, daß die gegenüber Strahlung empfindliche Schicht ein Siliciumnaphthalocyanin der Formel I

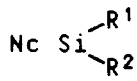 (I)

enthält, in der

Nc den Rest eines Naphthalocyaninsystems, das gegebenenfalls durch $C_1$-$C_{10}$-Alkyl oder $C_1$-$C_{10}$-Alkoxy substituiert ist, und

$R^1$ und $R^2$ gleich oder verschieden sind und unabhängig voneinander jeweils einen Rest der Formel

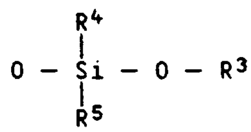 ,

in der $R^3$ für verzweigtes $C_6$-$C_{20}$-Alkyl der Formel

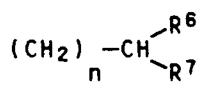 ,

wobei n die Bedeutung von 1 bis 5 und $R^6$ und $R^7$ gleich oder verschieden sind und unabhängig voneinander jeweils die Bedeutung von $C_1$-$C_{16}$-Alkyl besitzen, und $R^4$ und $R^5$ gleich oder verschieden sind und unabhängig voneinander jeweils für $C_1$-$C_{10}$-Alkyl oder den Rest $OR^3$, in dem $R^3$ die obengenannte Bedeutung besitzt, stehen, oder der Rest $R^1$ auch $C_1$-$C_{10}$-Alkyl bedeuten.

**4.** Dünne strahlungsempfindliche Beschichtungsfilme gemäß Anspruch 3, dadurch gekennzeichnet, daß sie ein Siliciumnaphtalocyanin der Formel I enthalten, in der Nc den Rest eines unsubstituierten Naphthalocyaninsystems bedeutet.

## Claims

**1.** A silicon naphthalocyanine of the formula I

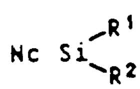 (I),

where

Nc is the radical of a naphthalocyanine system which may be unsubstituted or substituted by $C_1$-$C_{10}$-alkyl or $C_1$-$C_{10}$-alkoxy, and

$R^1$ and $R^2$ are identical or different and each is independently of the other a radical of the formula

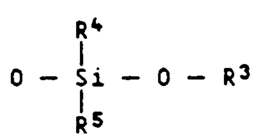 ,

where $R^3$ is branched $C_6$-$C_{20}$-alkyl of the formula

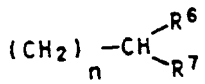 ,

where n is from 1 to 5 and $R^6$ and $R^7$ are identical or different and each is independently of the other $C_1$-$C_{16}$-alkyl, and $R^4$ and $R^5$ are identical or different and each is independently of the other $C_1$-$C_{10}$-alkyl or the radical $OR^3$ where $R^3$ is as defined above, or the radical $R^1$ may also be $C_1$-$C_{10}$-alkyl.

**2.** A silicon naphthalocyanine of the formula I as claimed in claim 1, wherein Nc is the radical of an unsubstituted naphthalocyanine system.

**3.** A thin radiation sensitive coating film containing a base and a radiation sensitive layer containing a silicon naphthalocyanine of the formula I

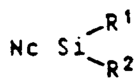 (I)

where

Nc is the radical of a naphthalocyanine system which may be substituted by $C_1$-$C_{10}$-alkyl or $C_1$-$C_{10}$-alkoxy, and

$R^1$ and $R^2$ are identical or different and each is independently of the other a radical of the formula

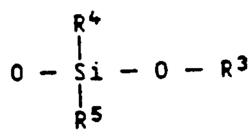 ,

where $R^3$ is branched $C_6$-$C_{20}$-alkyl of the formula

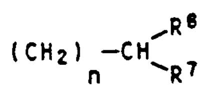 ,

where n is from 1 to 5 and $R^6$ and $R^7$ are identical or different and each is independently of the other $C_1$-$C_{16}$-alkyl, and $R^4$ and $R^5$ are identical or different and each is independently of the other $C_1$-$C_{10}$-alkyl or the radical $OR^3$ where $R^3$ is as defined above, or the radical $R^1$ may also be $C_1$-$C_{10}$-alkyl.

**4.** A thin radiation sensitive coating film as claimed in claim 3, which contains a silicon naphthalocyanine of the formula I where Nc is the radical of an unsubstituted naphthalocyanine system.

### Revendications

**1.** Naphtalocyanines de silicium de formule I

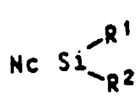 (I),

dans laquelle

Nc représente le reste d'un système naphtalocyanine qui est éventuellement substitué par un groupement alkyle en $C_1$-$C_{10}$ ou alcoxy en $C_1$-$C_{10}$, et

$R^1$ et $R^2$ sont identiques ou différents et représentent chacun, indépendamment de l'autre, un reste de formule

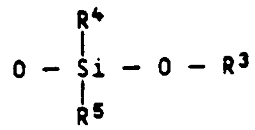

,

dans laquelle $R^3$ est un groupement alkyle ramifié en $C_6$-$C_{20}$ de formule

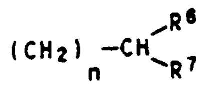

,

n étant compris entre 1 et 5 et $R^6$ et $R^7$ étant identiques ou différents et représentant chacun indépendamment de l'autre un groupement alkyle en $C_1$-$C_{16}$, et $R^4$ et $R^5$ sont identiques ou différents et représentent indépendamment l'un de l'autre un groupement alkyle en $C_1$-$C_{10}$ ou le reste $OR^3$, dans lequel $R^3$ a la même signification que précédemment, ou le reste $R^1$ représente également un groupement alkyle en $C_1$-$C_{10}$.

2. Naphtalocyanines de silicium de formule I selon la revendication 1, caractérisées en ce que Nc représente le reste d'un système naphtalocyanine non substitué.

3. Films Minces de revêtement sensibles aux rayonnements, contenant un support et une couche sensible aux rayonnements, caractérisés en ce que la couche sensible aux rayonnements contient une naphtalocyanine de silicium de formule I

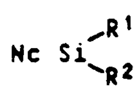

(I)

dans laquelle

Nc représente le reste d'un système naphtalocyanine qui est éventuellement substitué par un groupement alkyle en $C_1$-$C_{10}$ ou alcoxy en $C_1$-$C_{10}$, et

$R^1$ et $R^2$ sont identiques ou différents et représentent chacun, indépendamment de l'autre, un reste de formule

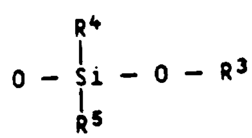

,

dans laquelle $R^3$ est un groupement alkyle ramifié en $C_6$-$C_{20}$ de formule

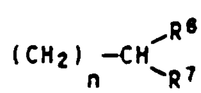

,

n étant compris entre 1 et 5 et $R^6$ et $R^7$ étant identiques ou différents et représentant

chacun indépendamment de l'autre un groupement alkyle en $C_1$-$C_{16}$, et $R^4$ et $R^5$ sont identiques ou différents et représentent indépendamment l'un de l'autre un groupement alkyle en $C_1$-$C_{10}$ ou le reste $OR^3$, dans lequel $R^3$ a la même signification que précédemment, ou le reste $R^1$ représente également un groupement alkyle en $C_1$-$C_{10}$.

**4.** Films Minces de revêtement sensibles aux rayonnements selon la revendication 3, caractérisés en ce qu'ils contiennent une naphtalocyanine de silicium de formule I, dans laquelle Nc représente le reste d'un système naphtalocyanine non substitué.